# EUROPEAN PATENT SPECIFICATION

(11) **EP 0 350 235 B1**
(45) Date of publication and mention of the grant of the patent: **13.04.1994**
(21) Application number: 89306727.2
(22) Date of filing: 03.07.1989
(51) Int. Cl.: G06K 19/06, H01M 6/40, H01M 2/10

(54) **A thin electronic card having an integrated circuit chip and battery and a method of producing same**
Dünne elektronische Karte mit IC-Chip und Batterie und Verfahren zu ihrer Herstellung
Carte électronique mince comprenant une puce de circuit intégré et une pile, et son procédé de fabrication

(30) Priority: 04.07.1988 JP 164895/88; 15.07.1988 JP 175061/88
(43) Date of publication of application: 10.01.1990
(73) Proprietor: SONY CORPORATION, Tokyo 141 (JP)
(72) Inventor: Nishi, Yoshio, Shinagawa-ku Tokyo (JP); Yasuda, Akio, Shinagawa-ku Tokyo (JP); Kashima, Tsunehiro, Shinagawa-ku Tokyo (JP); Hori, Takeshi, Shinagawa-ku Tokyo (JP); Higuchi, Shigetaka, Chuo-ku Tokyo (JP); Shimizu, Hidetoshi, Chuo-ku Tokyo (JP)
(74) Representative: Ayers, Martyn Lewis Stanley

(56) References cited:
- WO-A-85/00523
- FR-A- 2 595 847
- PATENT ABSTRACTS OF JAPAN, vol 9, no 185, (E-332)[1908] July 31, 1985 & JP-A-60-54 173
- PATENT ABSTRACTS OF JAPAN, vol 9, no 126, (E-318)[1849] May 31, 1985 & JP-A-60-12 679
- PATENT ABSTRACTS OF JAPAN, vol. 8, no. 271, (P-320)[1708], December 12, 1984 & JP-A-59-140 591

## Description

The present invention relates to a thin electronic card having an integrated circuit chip and an electrical battery for supplying electrical power to the integrated circuit chip, as well as to a method for producing same.

Recently, with the tendency to thinning of small-sized electronic devices, there have been developed items such as card-type electronic calculators having an integrated circuit chip between resin sheets and an electrical battery for supplying electrical power to the integrated circuit chip, as well as thin electronic devices such as IC cards having a memory function.

Heretofore, a button- or coin-shaped battery has been used in such small-sized electronic devices. The maximum thickness of such thin electronic devices is defined to be 0.80 mm by JIS. However, the use of a button- or coin-shaped battery in a thin electronic device has heretofore made it difficult to fabricate the electronic device within the rated maximum thickness imposed by this standard.

Recently, moreover, applications of such IC cards have been considered, for example, to theft detecting systems and automatic goods sorting systems, as disclosed in Japanese patent publication number 22997/84. Since it is necessary to provide a large number of IC cards as consumables, there has arisen the necessity of mass-producing IC cards inexpensively.

In the prior art, the body of the thin electronic device and the battery are produced separately and thereafter the battery is inserted into the body. This method, however, is very troublesome and low in productivity, leading to increased unit cost.

JP-A-6054173 discloses a thin electronic card corresponding to the precharacterising part of claim 8. In this prior art an integrated circuit and a battery power source therefor are disposed in side by side relation on one face of the substrate of the card.

It is an object to provide a card-type electronic device and its manufacturing method in which the mounting of the battery and I-C chip on the card substrate is improved.

According to one aspect of the present invention there is provided a method of producing an electronic card having an integrated circuit chip and an electrical battery for supplying electrical power to the integrated circuit chip, comprising:
a first printing step (13) of forming by printing an electroconductive pattern (4) comprising a first connecting conductor and a first electrode surfaces (4A₁) of a battery (5) on a first cover sheet (1);
a first application step (14) of applying a battery activator onto said first electrode surface (4A₁);
a resting step (17) of resting an electrolyte-impregnated separator (15) onto said first electrode surface;
a fixing step (21) of fixing an IC chip (6) to the connecting conductor of said electroconductive pattern (4) in a predetermined position;
a second printing step (25) of forming by printing a second connecting conductor and a second electrode surface (4B₁) of said battery (5) on a second cover sheet (2);
a second application step (26) of applying a battery activator onto said second electrode surface; and
a cutting step (30) of connecting the second connecting conductor with the I-C chip, lapping and sticking said first and said second cover sheet together to hold said I-C chip between the first and the second cover sheet (1,2) and cutting them to a predetermined size.

According to another aspect of the present invention there is provided a method of producing an electronic card having an integrated circuit chip and an electrical battery for supplying electrical power to the integrated circuit chip, comprising the steps of:
printing an electroconductive pattern (4) comprising connecting conductors and first (4A₁) and second (4B) electrode surfaces of a battery (5) onto integrally-formed first and second cover sheet portions;
applying an anodic active material and a cathodic active material onto said first and second electrode surfaces (4A₁, 4B), respectively;
fixing an IC chip (6) to said connecting conductors of said electroconductive pattern in a predetermined position;
resting an electrolyte-impregnated separator (5C) onto one of said first and second electrode surfaces; and
folding said first and second cover portions so as to be superposed one upon the other to hold said I-C chip between the first and the second cover sheet (1,2) and cutting them to a predetermined size.

According to a further aspect of the present invention there is provided a thin electronic card having an integrated circuit chip and an electrical battery for supplying electrical power to the integrated circuit chip including:
a first cover sheet (1) with an electroconductive pattern (4) comprising a first connecting conductor and a first electrode surface (4A₁) of a battery (5) printed thereon;
a second cover sheet (2) with a second connecting conductor and a second electrode surface (4B) of the battery (5) printed thereon;
an anodic active material applied onto said first electrode surface (4A₁);
a cathodic active material applied onto said second electrode surface (4B);
a separator (5C) impregnated with electrolyte;
an I-C chip (6) which is positioned between said first and said second cover sheet (1, 2); and
said connecting conductors formed on said first and said second cover sheet (1, 2) connecting said first and second electrode surfaces with said I-C chip.
said anodic active material and said cathodic active material being opposed to each other through the separator (5C), said first and said second cover sheets (1, 2) being laminated together to hold said I-C chip (6).

As will become apparent from the following description, the invention can provide a card-type electronic device and its manufacturing method which enables the device to be thinner than the conventional and and makes it easy and low in cost to manufacture the device.

The invention will be further described by way of non-limitative example with reference to the accompanying drawings, in which:-
Figure 1 is a schematic explanatory view of a method for producing an information card according to the present invention;
Figures 2(a), 2(b) and 2(c) are a plan view, a sectional side view and a separated side view respectively, of the information card;
Figures 3(a) to (g) are plan views of the information card in the course of manufacturing steps;
Figure 4 is an enlarged view of an IC chip;; and
Figures 5(a) to (c) are process charts showing another embodiment of the present invention.

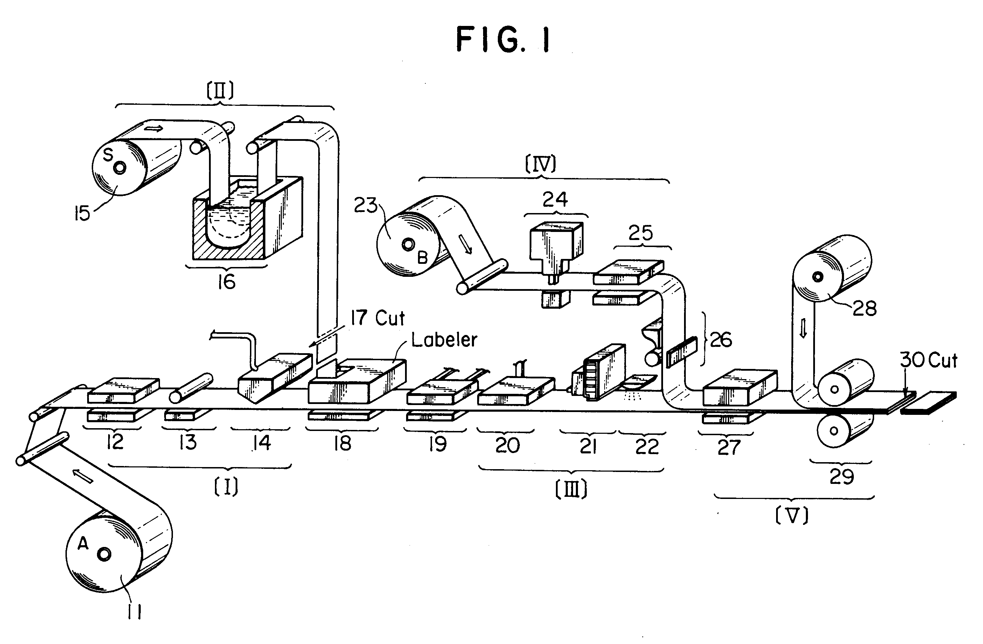

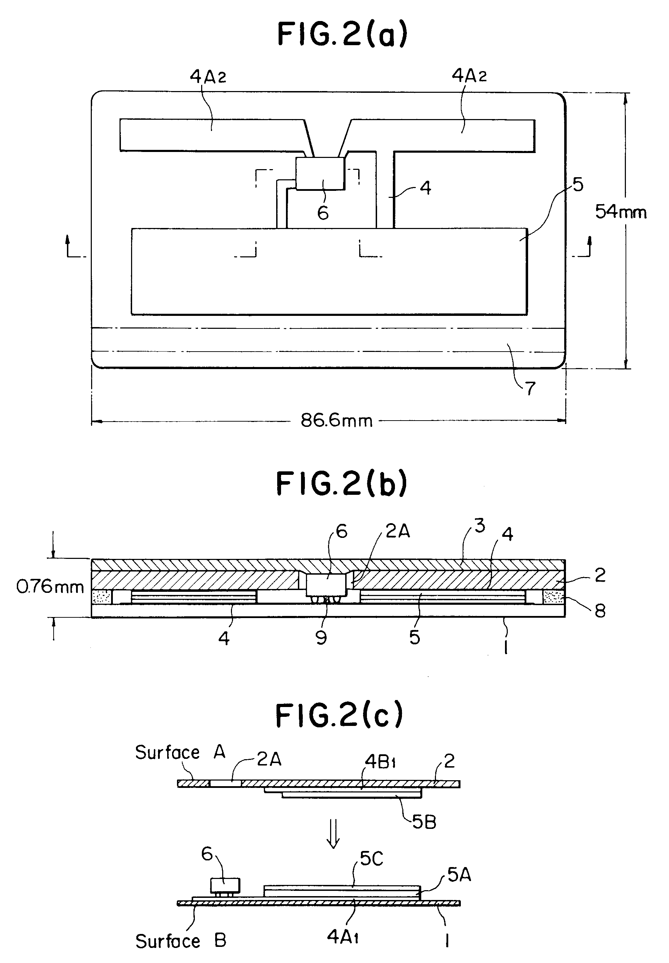

Figure 1 is a schematic view for explaining the method for producing a card according to the present invention. An example of a concrete structure of the information card thereby produced is shown in the plan view of figure 2(a), the sectional view of figures 2(b) and the separated side view of figure 2(c).

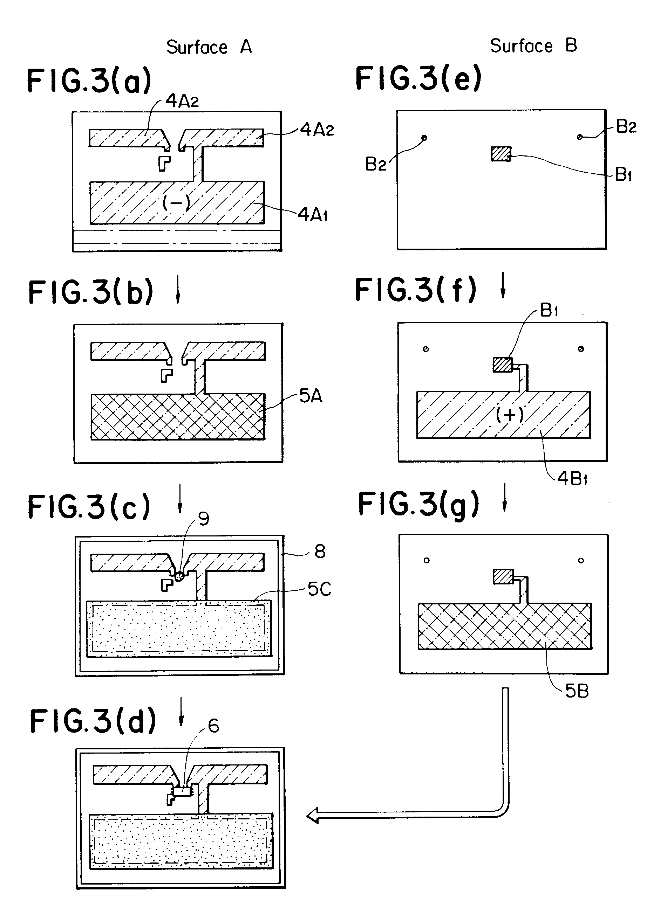

Patterns on the information card surface in the manufacturing steps of [I] to [V] are shown in figure 3.

For example, as shown in the plan view of figure 2(a) and sectional view of figure 2(b), the information card comprises a back-side cover sheet (hereinafter referred to also as the first cover sheet) 1 and a surface-side cover sheet (also as the second cover sheet hereinafter) 2. In the card of this embodiment, an adhesive sheet 3 is stuck on the upper surface of the surface-side cover sheet 2 to display the kind of card.

Between the first and the second cover sheet there are provided an electroconductive pattern 4, a flat battery 5 and an IC chip 6. For the purpose of reducing the thickness of the card, a hole 2A is formed in the second cover sheet 2 to accommodate the IC chip 6 when the first and the second cover sheet are lapped together.

Part of the electroconductive pattern 4, which is connected to the IC chip 6, serves as a pair of antennas (dipole antennas) 4A₂ whose characteristic impedance changes according to the data stored in the IC memory, while wider area portions thereof serve as positive and negative electrode surfaces 4A₁, 4B₁. This change in impedance may, as is well known, be used by a reader device to read data stored in the IC memory. The antenna can also be used to receive data transmitted to the card.

As best seen in figure 2(c), the battery 5 is formed by applying active materials 5A and 5B (Zn, MnO₂) of the battery in the state of a gel onto the electrode surfaces 4A₁ and 4B₁ which are formed by the printing technique or the like on the first and second cover sheets 1, 2, and then sandwiching an electrolyte-impregnated separator 5C in between the cover sheets 1 and 2.

On the outer surface of the first cover sheet 1 there may be formed a magnetic film 7 according to ISO standards as in ordinary magnetic cards such as credit cards.

An embodiment of the method of the present invention for producing a card as described above will be described hereinunder with reference to figure 1.

In figure 1, reference numeral 11 denotes a band-like cover sheet (A) formed of polyethylene terephthalate (PET) or polypropylene (P.P) and having a thickness of about 50 µm. The cover sheet 11 is drawn off of a supply roll in the illustrated direction and fed to a magnetic stripe printing section, wherein a magnetic film area according to ISO standards is formed on the lower surface of the cover sheet 11(A).

Numeral 13 denotes a screen printing section (A) for forming a wiring pattern on the upper surface of the cover sheet 11. In the screen printing section 13, a wiring pattern such as is shown in figure 3(a) is printed to the cover sheet 11, using an electroconductive coating material such as, for example, pasty carbon, copper which has been made pasty, or pasty mercury.

The portion 4A₁ of this wiring patten represents an electrode surface [4A₁ in figure 2(c)] serving as a negative (-) pole of the battery in the information card, while the portion 4A₂ represents an electroconductive surface serving as antenna.

Numeral 14 denotes an active material applying section for applying zinc (Zn) gel which acts as an activator in the battery to the portion 4A₁ which serves as an electrode surfaces as in figure 3(a), and in the portion indicated by rightwards oblique lines in figure 3(b), Zn gel 5A is applied onto the upper surface of the wiring pattern 4A₁ to a thickness of about 50 µm.

Numeral 15 denotes a separator sheet in the battery which sheet is formed by kraft paper for example. The separator sheet 15, which is rolled, passes through an electrolyte impregnating section 16, whereby it is impregnated with electrolyte, eg, ZnCl₂.

The thus electrolyte-impregnated separator 5C is cut into a predetermined size in a cutting section 17, then in a separator sticking section 18 it is placed on the electrode surface 4A₁ of the wiring pattern, as shown in figure 3(c).

By the above continuous steps there is constituted the first cover sheet 1 (surface A).

Then, in a mask mounting section 19, as shown in figure 3(c), a frame 8 is stuck to the first cover sheet having the surface A so as to slightly raise the peripheral portion of the wiring pattern. Further, in a hardener applying section 20, a small amount of a hardener 9 is applied to the first cover sheet 1 at the position at which the IC chip 6 is to be fixed.

At this time, a polyester-based hot melt adhesive is screen-printed to the outer peripheral portion of the electrode surface 4A₁.

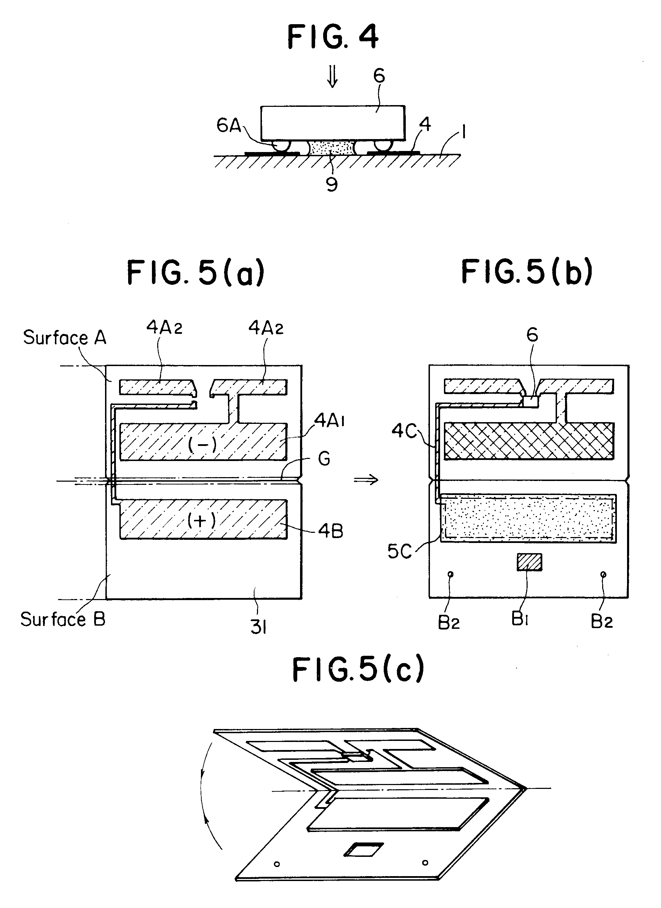

Numeral 21 denotes an IC chip packaging machine. IC chips 6 fed one by one from the IC chip packaging machine 21 are each pushed against the wiring pattern in a predetermined position. For example, as shown in the enlarged view of figure 4, lead terminals of the IC chip 6 are formed as bumps 6A, which are pushed against the wiring pattern 4 in predetermined positions. Then, infrared ray is radiated from an infrared ray radiating section 22 to the pre-applied hardener 9 to thereby fix the first cover sheet 1 and the IC chip 6 together.

Since the hardener 9 hardens and contracts upon radiation of infrared ray, the bumps 6A and the wiring pattern 4 make a good electrical contact.

The cover sheet of the surface A shown in figure 3(d) with the IC chip 6, battery active material and separator formed thereon is then lapped with a cover sheet 23 which serves as the second cover sheet 2 and both are stuck together.

More specifically, the cover sheet (B) (PET or P.P) 23, which is rolled, is drawn out in the arrowed direction and fed to a puncher 24, in which there are formed an aperture B₁ for the IC chip and apertures B₂ for antenna contact, as shown in figure 3(e).

The aperture B₁ is formed at a position corresponding to the mounted position of the IC chip fixed to the cover sheet of the surface A as mentioned above, while the apertures B₂ are formed in the positions corresponding to the antenna areas (4A₂, 4A₂).

The cover sheet (B) thus formed with the apertures B₁ and B₂ is then fed to a screen printing section (B) 25, in which an electroconductive wiring pattern such as that shown in figure 3(f) is printed to the cover sheet.

The greater part of the wiring pattern is in corresponding relation to the electrode surface (4A₁) of the surface A, forming a positive (+) electrode surface [4B₁ in figure 2(c)] of the battery.

Then, in an active material applying section (B) 26, for example zinc oxide 5B (ZnO₂) which is in the state of gel is applied as a depolarize to the electrode surface of the surface B to a thickness of about 50 µm to form the cover sheet of figure 3(g).

Preferably, at this time, a polyester-based hot melt adhesive is screen printed also to the outer peripheral portion of the electrode surface (4B₁).

This cover sheet (B) of the surface B and the foregoing cover sheet (A) of the surface A are lapped together and united, for example by heat-treating the two at 130°C for about 15 minutes or by an ultrasonic fusion-bonding technique, at station 27. At this time, the battery electrode surfaces are completely sealed by the hot melt adhesive.

In this case, it goes without saying that both sheets should be lapped together and united for registration between the pattern on the surface A and that on the surface B and in such a position as to permit the IC chip 6 to be embedded in the aperture B₁.

Numeral 28 denotes an adhesive tape, which is stuck to cover the apertures B₁ and B₂ of the cover sheet (B) which has been rendered integral with the other cover sheet by fusion-bonding for example.

Lastly, the integral sheet member is cut into a predetermined size (eg, a size according to ISO standards) by means of a cutter 30 to obtain such information card as shown in figure 2.

Although in the information card manufacturing method described above the cover sheets (11, 23) of the surfaces A and B which constitute the information card are fed separately, there may be used cover sheets (A) and (B) which are in a united state from the beginning.

More specifically, as shown in figure 5(a), a cover sheet 31 serving as both surfaces A and B has a groove G which permits folding upwards and downwards with respect to a central line. The surface of the cover sheet 31 is divided into surfaces A and B on both sides of the groove G, and wiring patterns 4A and 4B are printed on the surfaces A and B, respectively, using an electroconductive coating material.

As previously noted, Zn gel is applied to an electrode surface 4A₁ of the wiring pattern 4A, while ZnO₂ gel is applied to an electrode surface 4B₁ of the surface B. And as shown in figure 5(b), a separator 5C impregnated with electrolyte is put on the surface B, and apertures B₁ and B₂ are formed on the same surface.

Further, an IC chip 6 is fixed to the wiring pattern on the surface A using a hardener as noted previously and there is formed such cover sheet as shown in figure 5(b). The wiring patterns on the surfaces A and B of this cover sheet are connected together through an electroconductive path 4C extending across the groove G.

The cover sheet of figure 3(b) is folded along the groove G as shown in figure 3(c), to superpose the surfaces A and B together to form an information card.

Also in this second embodiment there are used most of the devices used in the manufacturing method illustrated in figure 1. The second embodiment is advantageous in that the screen printing sections 13, 25 and the active material applying sections 14, 26 can be gathered at one place, thus permitting further simplification of the manufacturing system.

## Claims

1. A method of producing an electronic card having an integrated circuit chip and an electrical battery for supplying electrical power to the integrated circuit chip, comprising:
a first printing step (13) of forming by printing an electroconductive pattern (4) comprising a first connecting conductor and a first electrode surfaces (4A₁) of a battery (5) on a first cover sheet (1);
a first application step (14) of applying a battery activator onto said first electrode surface (4A₁);
a resting step (17) of resting an electrolyte-impregnated separator (15) onto said first electrode surface;
a fixing step (21) of fixing an IC chip (6) to the connecting conductor of said electroconductive pattern (4) in a predetermined position; characterized in that it further comprises
a second printing step (25) of forming by printing a second connecting conductor and a second electrode surface (4B₁) of said battery (5) on a second cover sheet (2);
a second application step (26) of applying a battery activator onto said second electrode surface; and
a cutting step (30) of connecting the second connecting conductor with the I-C chip, lapping and sticking said first and said second cover sheet together to hold said I-C chip between the first and the second cover sheet (1,2) and cutting them to a predetermined size.

2. A method according to claim 1, wherein an antenna portion (4A₂) is also formed on the electroconductive pattern in said first printing step.

3. A method according to claim 2, wherein said electroconductive pattern and said first and second electrode surfaces are formed using carbon paste in said first (13) and second (25) printing steps.

4. A method according to claim 2 or 3, wherein the antenna portion of said electroconductive pattern constitutes a dipole antenna.

5. A method according to any one of claims 1 to 4, wherein a paste of one of anodic and cathodic active materials is printed onto the first electrode surface in said first application step, and a paste of the other of those active materials is printed onto the second electrode surface in said second application step (26).

6. A method according to any one of claims 1 to 5, wherein said resting step (17) comprises using kraft paper as said separator and impregnating said kraft paper with ZnCl₂ as electrolyte.

7. A method of producing an electronic card having an integrated circuit chip and an electrical battery for supplying electrical power to the integrated circuit chip, characterized in that it comprises the steps of:
printing an electroconductive pattern (4) comprising connecting conductors and first (4A₁) and second (4B) electrode surfaces of a battery (5) onto integrally-formed first and second cover sheet portions;
applying an anodic active material and a cathodic active material onto said first and second electrode surfaces (4A₁, 4B), respectively;
fixing an IC chip (6) to said connecting conductors of said electroconductive pattern in a predetermined position;
resting an electrolyte-impregnated separator (5C) onto one of said first and second electrode surfaces; and
folding said first and second cover portions so as to be superposed one upon the other to hold said I-C chip between the first and the second cover sheet (1,2) and cutting them to a predetermined size.

8. A thin electronic card having an integrated circuit chip and an electrical battery for supplying electrical power to the integrated circuit chip including:
a first cover sheet (1) with an electroconductive pattern (4) comprising a first connecting conductor and a first electrode surface (4A₁) of a battery (5) printed thereon;
a second cover sheet (2) with a second connecting conductor and a second electrode surface (4B) of the battery (5) printed thereon;
an anodic active material applied onto said first electrode surface (4A₁);
a cathodic active material applied onto said second electrode surface (4B);
a separator (5C) impregnated with electrolyte;
an I-C chip (6); and
said connecting conductors formed on said first and said second cover sheet (1, 2) connecting said first and second electrode surfaces with said I-C chip;
said anodic active material and said cathodic active material being opposed to each other through the separator (5C);
characterized in that said I-C chip is positioned between said first and said second cover sheet (1, 2); and
said first and said second cover sheets (1, 2) being laminated together to hold said I-C chip (6).

9. A thin electronic card according to claim 8, wherein an antenna portion (4A₂) is also printed on the electroconductive pattern (4).

10. A thin electronic card according to claim 9, wherein said first, second electrode surfaces and said connecting conductor are formed by screen-printing carbon paste onto said first and said second cover sheets (1, 2).

11. A thin electronic card according to claim 8, 9 or 10, wherein said anodic active material is formed by screen-printing MnO₂ paste onto said first electrode surface.

12. A thin electronic card according to any one of claims 8 to 11, wherein said cathodic active material is formed by screen-printing Zn paste onto said second electrode surface.

13. A thin electronic card according to claim 11 or 12, wherein the thickness of said anodic active material applied and that of said cathodic active material applied are in the range of 20 to 70 µm.

14. A thin electronic card according to any one of claims 8 to 13 and having a thickness not larger than 1 mm.

## Patentansprüche

1. Verfahren zur Herstellung einer elektronischen Karte mit einem eine integrierte Schaltung enthaltenden Chip und einer elektrischen Batterie zur Bereitstellung elektrischer Energie für den IC-Chip, welches umfaßt:
einen ersten Druckschritt (13) zum Ausbilden eines elektrisch leitenden Musters (4) mit einem ersten Anschlußleiter und einer ersten Elektrodenoberfläche (4A₁) einer Batterie (5) auf einer ersten Deckschicht (1);
einen ersten Auftrageschritt (14) zum Auftragen eines Batterieaktivierungsmittels auf die erste Elektrodenoberfläche (4A₁);
einen Auflageschritt (17) zum Auflegen eines mit einem Elektrolyten imprägnierten Trennelements (15) auf die erste Elektrodenoberfläche;
einen Befestigungsschritt (21) zum Befestigen eines IC-Chips (6) auf dem Anschlußleiter des elektrisch leitenden Musters (4) an einer vorgegebenen Position; dadurch gekennzeichnet, daß es weiterhin aufweist:
einen zweiten Druckschritt (25) zum Ausbilden mittels Drucken eines zweiten Anschlußleiters und einer zweiten Elektrodenoberfläche (4B₁) der Batterie (5) auf einer zweiten Deckschicht (2);
einen zweiten Auftrageschritt (26) zum Auftragen eines Batterieaktivierungsmittel auf die zweite Elektrodenoberfläche; und
einen Zuschneideschritt (30) zum Verbinden des zweiten Anschlußleiters mit dem IC-Chip, zum Überlappen und Zusammenkleben der ersten und zweiten Deckschicht, um den IC-Chip zwischen der ersten und zweiten Deckschicht (1, 2) zu halten, und zum Zuschneiden von diesen auf eine vorgegebene Größe.

2. Verfahren nach Anspruch 1, bei dem außerdem in dem ersten Druckschritt ein Antennenteil (4A₂) auf dem elektrisch leitenden Muster ausgebildet wird.

3. Verfahren nach Anspruch 2, bei dem das elektrisch leitende Muster und die erste und zweite Elektrodenoberfläche unter Verwendung von Kohlepaste in den ersten (13) und zweiten (25) Druckschritten ausgebildet werden.

4. Verfahren nach Anspruch 2 oder 3, bei dem der Antennenteil des elektrisch leitenden Musters eine Dipolantenne bildet.

5. Verfahren nach einem der Ansprüche 1 bis 5, bei dem eine Paste aus einem der anodischen oder katodischen aktiven Materialien in einem ersten Auftrageschritt auf die erste Elektrodenoberfläche gedruckt wird, und eine Paste aus dem anderen dieser aktiven Materialien in dem zweiten Auftrageschritt (26) auf die zweite Elektrodenoberfläche gedruckt wird.

6. Verfahren nach einem der Ansprüche 1 bis 5, bei dem der Auflageschritt (17) die Verwendung von Kraftpapier als Trennelement und das Imprägnieren des Kraftpapiers mit ZnCl₂ als Elektrolyt umfaßt.

7. Verfahren zur Herstellung einer elektrischen Karte mit einem IC-Chip und einer elektrischen Batterie zur Bereitstellung von elektrischer Energie für den IC-Chip, dadurch gekennzeichnet, daß es umfaßt:
Drucken eines elektrisch leitfähigen Musters (4), welches Verbindungsleiter und erste (4A₁) und zweite (4B) Elektrodenoberflächen einer Batterie (5) auf aus einem Stück ausgebildeten ersten und zweiten Deckschichtteilen enthält;
Auftragen jeweils eines anodischen aktiven Materials und eines katodischen aktiven Materials auf die erste und zweite Elektrodenoberfläche (4A₁, 4B);
Befestigen eines IC-Chips (6) an den Anschlußleitern des elektrisch leitenden Musters in einer vorgegebenen Position;
Auflegen eines mit einem Elektrolyten imprägnierten Trennelements (5C) auf eine der ersten oder zweiten Oberflächen; und
Falten der ersten und zweiten Deckteile, damit eins über dem anderen angeordnet ist, um den IC-Chip zwischen der ersten und zweiten Deckschicht (1, 2) zu halten, und diese auf eine vorgegebene Größe schneiden.

8. Dünne elektronische Karte mit einm IC-Chip und einer elektrischen Batterie zur Bereitstellung von elektrischer Energie für den IC-Chip, welche enthält:
eine erste Deckschicht (1) mit einem elektrisch leitenden Muster (4), welches einen ersten Anschlußleiter und eine erste Elektrodenoberfläche (4A₁) einer Batterie enthält, welche darauf gedruckt sind;
ein anodisches aktives Material, welches auf die erste Elektrodenoberfläche (4A₁) aufgelegt ist;
ein katodisches aktives Material, welches auf die zweite Elektrodenoberfläche (4B) aufgelegt ist;
ein mit einem Elektrolyten imprägniertes Trennelement (5C);
einen IC-Chip; und
bei der die auf der ersten und zweiten Deckschicht (1, 2) ausgebildeten Anschlußleiter die erste und zweite Elektrodenoberfläche mit dem IC-Chip verbinden;
wobei das anodische aktive Material und das katodische aktive Material über das Trennelement (5C) einander gegenüberliegen;
dadurch gekennzeichnet, daß der IC-Chip zwischen der ersten und zweiten Deckschicht (1, 2) angeordnet ist; und die erste und zweite Deckschicht miteinander laminiert sind, um den IC-Chip zu halten.

9. Dünne elektronische Karte nach Anspruch 8, bei der außerdem auf dem elektrisch leitenden Muster (4) ein Antennenteil (4A₂) gedruckt ist.

10. Dünne elektronische Karte nach Anspruch 9, bei der die erste, zweite Elektrodenoberfläche und die Anschlußleiter mittels Kohlepaste im Siebdruck auf die erste und zweite Deckschicht (1, 2) ausgebildet sind.

11. Dünne elektronische Karte nach Anspruch 8, 9 oder 10, bei der das anodische aktive Material mittels einer MnO₂-Paste im Siebdruck auf der erste Elektrodenoberfläche ausgebildet ist.

12. Dünne elektronische Karte nach einem der Ansprüche 8 bis 11, bei der das katodische aktive Material mittels einer Zn-Paste im Siebdruck auf der zweiten Elektrodenoberfläche ausgebildet ist.

13. Dünne elektronische Karte nach Anspruch 11 oder 12, bei der die Dicke des aufgebrachten anodischen aktiven Materials und jene des aufgebrachten katodischen aktiven Materials in dem Bereich von 20 bis 70 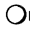 m liegt.

14. Dünne elektronische Karte nach einem der Ansprüche 8 bis 13 und mit einer Dicke, welche nicht größer als 1mm ist.

## Revendications

1. Procédé de production d'une carte électronique possédant un composant de circuit intégré et une batterie électrique pour fournir une puissance électrique au composant de circuit intégré, procédé comprenant les étapes suivantes :
- une première étape d'impression (13) pour la formation par impression d'un motif électro-conducteur (4) comprenant un premier conducteur de raccordement et une première surface d'électrode (4A₁) d'une batterie (5) sur une première feuille de recouvrement (1);
- une première étape d'application (14) pour l'application d'un activateur de batterie sur ladite première surface d'électrode (4A₁);
- une étape de dépôt (17) d'un séparateur imprégné d'un électrolyte (15) sur ladite première surface d'électrode;
- une étape de fixation (21) d'un composant IC (6) sur le conducteur de raccordement dudit motif électro-conducteur (4) dans une position prédéterminée;
procédé caractérisé en ce qu'il comprend, de plus, les étapes suivantes :
- une seconde étape d'impression (25) pour la formation par impression d'un second conducteur de raccordement et d'une seconde surface d'électrode (4B₁) de ladite batterie (5) sur une seconde feuille de recouvrement (2);
- une seconde étape d'application (26) d'un activateur de batterie sur ladite seconde surface d'électrode; et
- une étape de découpe (30) pour le raccordement du second conducteur de raccordement au composant IC (6), pour l'application et le collage desdites première et seconde feuilles de recouvrement afin de maintenir ledit composant IC (6) entre la première et la seconde feuilles de recouvrement (1, 2) et pour leur découpe à une taille prédéterminée.

2. Procédé selon la revendication 1, selon lequel une partie d'antenne (4A₂) est aussi formée sur le motif électro-conducteur lors de ladite première étape d'impression.

3. Procédé selon la revendication 2, selon lequel ledit motif électro-conducteur et lesdites première et seconde surfaces d'électrode sont formés à l'aide d'un carbone amorphe lors desdites première (13) et seconde (25) étapes d'impression.

4. Procédé selon la revendication 2 ou 3, selon lequel la partie d'antenne dudit motif électro-conducteur constitue une antenne à deux pôles.

5. Procédé selon l'une quelconque des revendications 1 à 4, selon lequel une pâte de l'un des matériaux actifs d'anode et de cathode est formée par impression sur ladite première surface d'électrode lors de ladite première étape d'application et une pâte de l'autre de ces matériaux actifs est formée par impression sur la seconde surface d'électrode lors de ladite seconde étape d'application (26).

6. Procédé selon l'une quelconque des revendications 1 à 5, selon lequel ladite étape de dépôt (17) comprend l'utilisation d'un papier kraft comme ledit séparateur et l'imprégnation dudit papier kraft de ZnCl₂ comme électrolyte.

7. Procédé de production d'une carte électronique possédant un composant de circuit intégré et une batterie électrique pour fournir une puissance électrique au composant de circuit intégré, caractérisé en ce qu'il comprend les étapes suivantes :
- l'impression d'un motif électro-conducteur (4) comprenant des conducteurs de raccordement et une première (4A₁) et une seconde (4B) surfaces d'électrode d'une batterie (5) sur des première et seconde parties de feuille de recouvrement formées de façon intégrale;
- l'application d'un matériau actif d'anode et d'un matériau actif de cathode respectifs sur lesdites première et seconde surfaces d'électrode (4A₁, 4B);
- la fixation d'un composant IC (6) auxdits conducteurs de raccordement dudit motif électro-conducteurs dans une position prédéterminée;
- le dépôt d'un séparateur imprégné d'un électrolyte (5C) sur une desdites première et seconde surfaces d'électrode; et
- le pliage desdites première et seconde parties de recouvrement de façon à être superposées l'une sur l'autre pour maintenir ledit composant IC (6) entre la première et la seconde feuilles de recouvrement (1, 2) et leur découpe à une taille prédéterminée.

8. Carte électronique mince possédant un composant de circuit intégré et une batterie électrique pour fournir une puissance électrique au composant de circuit intégré, comprenant :
- une première feuille de recouvrement (1) munie d'un motif électro-conducteur (4) comprenant un premier conducteur de raccordement et une première surface d'électrode (4A₁) d'une batterie (5) imprimés dessus;
- une seconde feuille de recouvrement (2) munie d'un second conducteur de raccordement et d'une seconde surface d'électrode (4B) de la batterie (5) imprimés dessus;
- un matériau actif d'anode appliqué sur ladite première surface d'électrode (4A₁);
- un matériau actif de cathode appliqué sur ladite seconde surface d'électrode (4B);
- un séparateur (5C) imprégné d'un électrolyte;
- un composant IC (6); et
lesdits conducteurs de raccordement ainsi formés sur ladite première et ladite seconde feuilles de recouvrement (1, 2) raccordant ladite première et ladite seconde surfaces d'électrode audit composant IC (6);
ledit matériau actif d'anode et ledit matériau actif de cathode étant en opposition via le séparateur (5C);
carte caractérisée en ce que ledit composant IC (6) est placé entre ladite première et ladite seconde feuilles de recouvrement (1, 2) et en ce que ladite première et ladite seconde feuilles de recouvrement (1, 2) sont stratifiées pour maintenir ledit composant IC (6).

9. Carte électronique mince selon la revendication 8, dans laquelle une partie d'antenne (4A₂) est imprimée, de même, sur le motif électro-conducteur (4).

10. Carte électronique mince selon la revendication 9, dans laquelle lesdites première et seconde surfaces d'électrode et ledit conducteur de raccordement sont formés par impression par sérigraphie d'un carbone amorphe sur ladite première et ladite seconde feuilles de recouvrement (1, 2).

11. Carte électronique mince selon la revendication 8, 9 ou 10, dans laquelle ledit matériau actif d'anode est formé par impression par sérigraphie d'une pâte de MnO₂ sur ladite première surface d'électrode.

12. Carte électronique mince selon l'une quelconque des revendications 8 à 11, dans laquelle ledit matériau actif de cathode est formé par impression par sérigraphie d'une pâte de Zn sur ladite seconde surface d'électrode.

13. Carte électronique mince selon la revendication 11 ou 12, dans laquelle l'épaisseur dudit matériau actif d'anode appliqué et celle dudit matériau actif d'anode appliqué sont comprises entre 20 et 70 µm.

14. Carte électronique mince selon l'une quelconque des revendications 8 à 13, possédant une épaisseur ne dépassant pas 1 mm.
